# EUROPEAN PATENT SPECIFICATION

(11) **EP 0 677 751 B1**
(45) Date of publication and mention of the grant of the patent: **18.10.2000**
(21) Application number: 95104102.9
(22) Date of filing: 20.03.1995
(51) Int. Cl.: G01R 33/3873

(54) **Improvements in or relating to magnetic resonance imaging apparatus**
Verbesserungen an oder mit Bezug auf Geräte zur Bilderzeugung durch magnetische Resonanz
Améliorations de ou en relation avec appareils d'imagerie magnétique

(30) Priority: 13.04.1994 GB 9407309; 29.04.1994 GB 9408543
(43) Date of publication of application: 18.10.1995
(73) Proprietor: OXFORD MAGNET TECHNOLOGY LIMITED, Eynsham Oxford OX8 1BP (GB)
(72) Inventor: Allis, Jonathan Leslie, Iffley, Oxford OX4 4JB (GB); Smith, Philip Nigel, Milton Keynes MK19 6EW (GB); Gilgrass, Graham, Sutton, Oxford OX8 1RZ (GB)
(74) Representative: Mackett, Margaret Dawn

(56) References cited:
- EP-A- 0 216 404
- EP-A- 0 460 762
- MAGNETIC RESONANCE IN MEDICINE, vol. 6, 1988 DULUTH, USA, pages 459-473, L. BRATEMAN ET AL.: 'Magnetic Field Shimming by Fourier Analysis'
- PATENT ABSTRACTS OF JAPAN vol. 14 no. 246 (C-0722) ,25 May 1990 & JP-A-02 068038 (TOSHIBA CORP) 7 March 1990,
- PATENT ABSTRACTS OF JAPAN vol. 9 no. 327 (P-415) [2050] ,21 December 1985 & JP-A-60 151546 (HITACHI SEISAKUSHO K.K.) 9 August 1985,

## Description

This invention relates to magnetic resonance imaging (MRI) apparatus and more particularly it relates to magnets for use in such apparatus.

An example of an MRI system is shown in European patent number 0216404 which describes a magnet system as recited in the preamble of claim 1.

The principle of operation of MRI apparatus, (more especially as used for medical applications), and the requirements for design and construction of magnets used in such apparatus is generally well-known to those skilled in the art. Accordingly, a detailed discussion of this subject for the purposes of the present invention is believed to be unnecessary, but nevertheless some fundamental requirements for successful operation of the apparatus will now be considered.

One of the principal requirements for high quality imaging is the provision of a highly homogeneous magnetic field in an imaging volume, i.e. a region wherein that part of a patient to be scanned is positioned. Homogeneity is known to be improved by the inclusion of precisely positioned mild steel shimming rings in the 'warm bore' of a cryogenic annular magnet, i.e. shimming rings positioned on the imaging volume side of a cryogenic container or cryostat used to house a super-conducting magnet.

Unfortunately, eddy currents are produced in these shims, as primary magnetic field gradient coils are pulsed on and off (which pulsing is a fundamental part of the imaging process), which adversely affect the image quality.

In order to minimise this effect, active shielding is provided by means of secondary gradient coils, which generate shielding magnetic fields effective to produce cancellation of the field gradients in predetermined regions. Active magnetic shield gradients are usually designed to produce a zero magnetic field in a region spaced apart by several centimetres from the shims and a compromise design is therefore difficult, if not impossible, to produce, especially if the shims are positioned between the primary and secondary gradient coils, or on the 'warm bore' or patient side of the coils, as may be necessary for optimum magnetic homogeneity.

It is an object of the present invention to provide for elimination, or at least a substantial reduction, of eddy currents in shimming rings of an MRI magnet, whereby image quality is improved.

According to the present invention, there is provided a magnet for generating a magnetic field in an imaging volume of a Magnetic Resonance Imaging (MRI) apparatus, said magnet having means for generating said magnetic field, gradient coils, and shimming rings disposed in operative association with said magnetic field so as to produce a substantial homogeneous magnetic field in said imaging volume, characterised in that said shimming rings are formed from mutually electrically insulated contiguous turns of iron or steel wire wound so as to circumscribe a volume associated with said imaging volume, so that as the gradient coils are pulsed 'on' and 'off' in accordance with an imaging process, a substantial reduction in eddy current produced by said gradient coils in said shims is effected.

The wire used for forming said shimming rings is square or rectangular in cross-section has a thickness to width ratio which is chosen to provide optimum packing density and for optimum suppression of the propagation of eddy currents.

The shimming rings further include additional balancing turns of wire wound in association with said rings so as to substantially improve the homogeneity of said magnetic field.

The cross-section of wire used for said additional balancing turns is different to the cross-section of the wire used for said shimming rings.

The turns of the wire forming said shimming rings comprise two or more sub-windings wound in opposing directions so as substantially to reduce the effects of voltages induced therein.

The turns of the wire forming said shimming rings are segmented so that induced voltages are substantially inhibited.

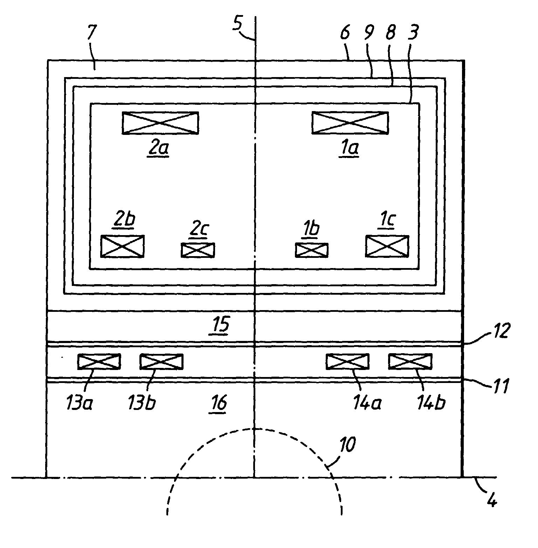

One embodiment of the invention will now be described by way of example only with reference to the accompanying drawing, which is a schematic sectional view of part of a super-conducting magnet used in MRI apparatus.

Referring now to the drawings, a super-conducting magnet for MRI apparatus comprises magnet coils 1a, 1b, 1c and 2a, 2b, 2c, which are arranged within a vessel 3 filled with liquid helium. It will be appreciated that the magnet is symmetrical about its longitudinal axis 4, through which the sectional view is taken and accordingly for simplicity, an upper half only of the sectional view is shown. The magnet is also generally symmetrical about a vertical axis 5 and, as can be seen from the drawing, the magnet coils 1a, 1b and 1c are positioned to the right of the vertical axis 5 and are similar to the coils 2a, 2b and 2c which are positioned to the left of the vertical axis 5.

The vessel 3 is contained within a wall 6 of a sealed outer chamber, and a space 7 defined between the vessel 3 and the wall 6 of the outer chamber, is evacuated to minimise heat gain by convection and thereby to provide good insulation. Additionally, in the evacuated space 7, inner and outer aluminium cryoshields 8 and 9 respectively, are provided to minimise heat gain by radiation.

A cylindrical region (often described as the 'warm bore' of a magnet) disposed within the annular super-conducting magnet coils 1a, 1b, 1c and 2a, 2b 2c, includes a generally spherical imaging volume as shown by broken line 10, wherein optimum homogeneity of the magnetic field obtains and wherein that part of a patient to be scanned is positioned. In this region, primary gradient coils 11 are positioned together with secondary shield gradient coils 12, which serve to produce a shield magnetic field in opposition to the field produced by the primary gradient coils. In order to produce homogeneity of the magnetic field in the 'warm bore' shimming rings 13a, 13b and 14a, 14b are provided between the primary and secondary gradient coils 11 and 12. Although the shimming rings 13a, 13b and 14a, 14b are shown located between the gradient coils 11, 12, they may alternatively be located above the secondary shield gradient coil 12 in a space 15, or below the primary gradient coil 11 in a space 16.

In order to prevent the undesirable build up of eddy currents in the shimming rings 13a, 13b and 14a, 14b, the rings are fabricated, using a winding technique, of turns made of iron or mild steel which are mutually insulated from each other. The magnetic performance of the wire wound shimming rings may be adjusted by means of physical movement of their position in the bore and/or by winding additional balancing turns. The wire used for the balancing turns would be of suitable shape and size, which may or may not correspond to the wire from which the shimming rings are fabricated. Wire winding of the shimming rings allows both ease of manufacture and the possibility of balancing turns on the shimming rings. Constancy of packing density is maintained by holding the winding tension at a constant level. These factors render wire winding far superior to the other techniques of lamination, e.g. stacking sheets of steel plate.

In order to provide good packing density, the wire form which the shimming rings are wound is preferably square or rectangular in cross-section, the thickness to width ratio being chosen to provide optimum packing density and anti-eddy current propagation characteristics. The wire may be insulated using any suitable technique such as enamel or plastics coating for example, which may be applied using an electrostatic process, or by using a wet coating process. Alternatively, however, the insulation may comprise wound tape or a braided cover. It will be appreciated that the quality of the insulation is chosen having regard to the break down voltage required which is dependent upon the voltages produced during gradient pulsing. Prior to being insulated, the wire material will normally be frilly annealed to produce suitable soft magnetic properties. Iron or mild steel wire is suitable for the shims having a carbon content of less than .1%. Typically the presence of other residual elements is kept to less than .4%. Conveniently, the wire may be manufactured by a rolling or drawing process, annealing being carried out as a final stage in the manufacturing operation.

Advantageously layers of turns or groups of layers of turns may be wound in opposing directions thereby to cancel out voltages induced during gradient pulsing. Additionally, or alternatively, the winding may be segmented whereby induced voltages are not permitted to build up. Alternatively, in order to prevent the build up of the induced voltages, wire may be used which is not electrically continuous.

Various modifications may be made to the arrangement just before described, without departing from the scope of the invention and for example, although a super-conducting magnet has been just before described, it will be appreciated that similar techniques may be used for other high flux non super-conducting magnet assemblies.

## Claims

1. A magnet for generating a magnetic field in an imaging volume (10) of a Magnetic Resonance Imaging (MRI) apparatus, said magnet having means (1a, 1b, 1c; 2a, 2b, 2c) for generating said magnetic field, gradient coils (11, 12), and shimming rings (13a, 13b; 14a, 14b) disposed in operative association with said magnetic field in said imaging volume (10), characterised in that said shimming rings are formed from mutually electrically insulated contiguous turns of iron or steel wire wound so as to circumscribe a volume associated with said imaging volume (10), so that as the gradient coils (11,12) are pulsed 'on' and 'off' in accordance with an imaging process, a substantial reduction in eddy current produced by said gradient coils (11,12) in said shims (13a, 13b; 14a, 14b) is effected.

2. A magnet as claimed in Claim 1, wherein the wire used for forming said shimming rings (13a, 13b; 14a, 14b) is square or rectangular in cross-section has a thickness to width ratio which is chosen to provide optimum packing density and for optimum suppression of the propagation of eddy currents.

3. A magnet as claimed in Claim 2, wherein said shims (13a, 13b; 14a, 14b) further include additional balancing turns of wire wound in association with said shimming rings so as to substantially improve the homogeneity of said magnetic field.

4. A magnet as claimed in Claim 3, wherein a cross-section of the wire used for said additional balancing turns is different to the cross-section of the wire used for said shimming rings.

5. A magnet as claimed in Claim 1, wherein said turns of wire forming said shimming rings comprise two or more sub-windings wound in opposing directions so as substantially to reduce the effects of voltages induced therein.

6. A magnet as claimed in Claim 1, wherein said turns of wire forming said shimming rings are segmented so that induced voltages are substantially inhibited.

7. A magnet as claimed in Claim 1, wherein said means for generating a magnetic field is in a super-conducting magnet.

8. A Magnetic Resonance Imaging apparatus including a magnet as claimed in any preceding claim.

## Patentansprüche

1. Magnet zum Erzeugen eines Magnetfeldes in einem Abbildungsvolumen (10) einer Magnetresonanz-Abbildungsvorrichtung (MRI-Vorrichtung), wobei der Magnet ein Mittel (1a, 1b, 1c; 2a, 2b, 2c) zum Erzeugen des Magnetfeldes, Gradientenspulen (11, 12) und Korrekturringe (13a, 13b; 14a, 14b), die in funktionaler Zuordnung zu dem Magnetfeld im Abbildungsvolumen (10) angeordnet sind, umfaßt, dadurch gekennzeichnet, daß die Korrekturringe aus voneinander elektrisch isolierten, nebeneinanderliegenden Windungen aus Eisen- oder Stahldraht, der so gewickelt ist, daß er ein dem Abbildungsvolumen (10) zugeordnetes Volumen begrenzt, gebildet sind, so daß bei impulsartigem Ein- und Ausschalten der Gradientenspulen (11, 12) in Übereinstimmung mit einem Abbildungsprozeß eine wesentliche Verringerung des durch die Gradientenspulen (11, 12) in den Korrekturringen (13a, 13b; 14a, 14b) erzeugten Wirbelstroms bewerkstelligt wird.

2. Magnet nach Anspruch 1, bei dem der für die Bildung der Korrekturringe (13a, 13b; 14a, 14b) verwendete Draht einen quadratischen oder rechtwinkligen Querschnitt und ein Dicken/Breiten-Verhältnis besitzt, das so gewählt ist, daß eine optimale Packungsdichte und eine optimale Unterdrückung der Ausbreitung von Wirbelströmen erhalten wird.

3. Magnet nach Anspruch 2, bei dem die Korrekturringe (13a, 13b; 14a, 14b) ferner zusätzliche Draht-Ausgleichswindungen enthalten, die in Zuordnung zu den Korrekturringen gewickelt sind, um die Homogenität des Magnetfeldes wesentlich zu verbessern.

4. Magnet nach Anspruch 3, bei dem ein Querschnitt des für die zusätzlichen Ausgleichswindungen verwendeten Drahts vom Querschnitt des für die Korrekturringe verwendeten Drahts verschieden ist.

5. Magnet nach Anspruch 1, bei dem die Windungen des die Korrekturringe bildenden Drahts zwei oder mehr Unterwicklungen umfassen, die in entgegengesetzten Richtungen gewickelt sind, um die Wirkungen von darin induzierten Spannungen wesentlich zu reduzieren.

6. Magnet nach Anspruch 1, bei dem die Windungen des die Korrekturringe bildenden Drahts segmentiert sind, so daß induzierte Spannungen im wesentlichen verhindert werden.

7. Magnet nach Anspruch 1, bei dem das Mittel zum Erzeugen eines Magnetfeldes ein supraleitender Magnet ist.

8. Magnetresonanz-Abbildungsvorrichtung, die einen Magneten nach irgendeinem vorhergehenden Anspruch enthält.

## Revendications

1. Aimant pour générer un champ magnétique dans un volume d'imagerie (10) d'un appareil d'imagerie par résonance magnétique (IRM), ledit aimant comportant des moyens (1a, 1b, 1c ; 2a, 2b, 2c) pour générer ledit champ magnétique, des bobines de gradient (11, 12) et des bagues d'ajustage (13a, 13b ; 14a, 14b) disposées en association fonctionnelle avec ledit champ magnétique dans ledit volume d'imagerie (10), caractérisé en ce que lesdites bagues d'ajustage sont formées de spires contiguës mutuellement électriquement isolées de fil de fer ou d'acier bobinées de façon à circonscrire un volume associé audit volume d'imagerie (10), de sorte que lorsque les bobines de gradient (11, 12) reçoivent des impulsions 'd'activation' et de 'désactivation' selon un processus d'imagerie, une réduction sensible du courant de Foucault produit par lesdites bobines de gradient (11, 12) dans lesdites bagues d'ajustage (13a, 13b ; 14a, 14b) est réalisée.

2. Aimant selon la revendication 1, dans lequel le fil utilisé pour former lesdites bagues d'ajustage (13a, 13b ; 14a, 14b) est carré ou rectangulaire en section transversale, possède un rapport épaisseur sur largeur qui est choisi de manière à fournir une densité d'occupation optimale et pour la suppression optimale de la propagation des courants de Foucault.

3. Aimant selon la revendication 2, dans lequel lesdites bagues d'ajustage (13a, 13b ; 14a, 14b) comportent en outre des spires d'équilibrage supplémentaires de fil, bobinées en association avec lesdites bagues d'ajustage, de façon à améliorer sensiblement l'homogénéité dudit champ magnétique.

4. Aimant selon la revendication 3, dans lequel la section transversale du fil utilisé pour lesdites spires d'équilibrage supplémentaires est différente de la section transversale du fil utilisé pour lesdites bagues d'ajustage.

5. Aimant selon la revendication 1, dans lequel lesdites spires du fil formant lesdites bagues d'ajustage comprennent deux bobinages secondaires ou davantage, bobinés dans des directions opposées, de manière à réduire sensiblement les effets des tensions induites dans celles-ci.

6. Aimant selon la revendication 1, dans lequel lesdites spires du fil formant lesdites bagues d'ajustage sont segmentées de façon que les tensions induites soient sensiblement inhibées.

7. Aimant selon la revendication 1, dans lequel lesdits moyens pour générer un champ magnétique sont constitués d'un aimant supraconducteur.

8. Appareil d'imagerie par résonance magnétique comportant un aimant selon l'une quelconque des revendications précédentes.
